# EUROPÄISCHE PATENTSCHRIFT

(11) **EP 3 181 721 B1**
(45) Veröffentlichungstag und Bekanntmachung des Hinweises auf die Patenterteilung: **18.11.2020**
(21) Anmeldenummer: 16203731.1
(22) Anmeldetag: 13.12.2016
(51) Int. Cl.: C23C 16/40, C23C 16/54, C23C 16/56, C23C 16/50

(54) **VERFAHREN ZUM HERSTELLEN EINES SCHICHTVERBUNDES BESTEHEND AUS EINER KUNSTSTOFFFOLIE UND EINER DARAUF ABGESCHIEDENEN SCHICHT**
METHOD FOR PRODUCING A LAMINATED COMPOSITE CONSISTING OF A FILM OF PLASTIC MATERIAL AND A LAYER DEPOSITED THEREON
PROCÉDÉ DE FABRICATION D'UN COMPOSITE STRATIFIÉ COMPOSÉ D'UNE FEUILLE DE PLASTIQUE ET D'UNE COUCHE SÉPARÉE POSÉE DESSUS

(30) Priorität: 16.12.2015 DE 102015122024
(43) Veröffentlichungstag der Anmeldung: 21.06.2017
(73) Patentinhaber: Fraunhofer-Gesellschaft zur Förderung der angewandten Forschung e.V., 80686 München (DE)
(72) Erfinder: DRESE, Hendrik, 07973 Greiz (DE); FAHLTEICH, John, 01279 Dresden (DE); SCHWARZ, Wolfgang, 01279 Dresden (DE); RÖGNER, Frank-Holm, 01277 Dresden (DE); SCHILLER, Nicolas, 01833 Stolpen OT Helmsdorf (DE)

(56) Entgegenhaltungen:
- EP-A1- 0 887 433
- CN-B- 101 894 747
- DE-A1- 2 935 397
- JP-A- 2014 133 349
- US-A1- 2012 052 244

## Beschreibung

Die Erfindung betrifft ein Verfahren zum Abscheiden einer organisch modifizierten siliziumhaltigen Schicht auf einer Kunststofffolie mittels einer plasmaunterstützten chemischen Gasphasenabscheidung im Vakuum, wobei der entstehende Schichtverbund eine gegenüber dem Stand der Technik verbesserte Dehnbarkeit aufweist.

Für das Abscheiden von Funktionsschichten auf verschiedenen Substraten ist eine Vielzahl von Verfahren bekannt. CN 101 894 747 B offenbart beispielsweise Verfahren für das Herstellen von kristallinen Siliziumschichten auf Glassubstraten, wobei zunächst eine amorphe Siliziumschicht auf den Glassubstraten abgeschieden und anschließend mit einem Elektronenstrahl erhitzt wird, so dass die Siliziumschicht aufgeschmolzen wird, welche dann beim Abkühlen kristallisiert.

Aus DE 29 35 397 A1 sind Verfahren zum Herstellen von Halbleitermaterial bekannt. Hierbei wird zunächst eine amorphe Schicht aus einem Halbleitermaterial auf einem flexiblen Substrat abgeschieden, nach erfolgter Schichtabscheidung die Schicht vom Substrat getrennt und anschließend die vom Substrat abgelöste Schicht erhitzt, um das amorphe Schichtmaterial in einen kristallinen Zustand zu überführen. Dabei kann das Erhitzen der abgelösten Schicht mittels eines Elektronenstrahls erfolgen.

EP 0 887 433 A1 beschreibt Verfahren zum Herstellen von Kratzschutzschichten auf verschiedenen Substraten, die beispielsweise mittels plasmaunterstütztem Elektronenstrahlverdampfen abgeschieden werden können.

Es ist ferner bekannt, Funktionsschichten auf die Oberfläche von Kunststofffolien aufzutragen oder Schichten, um beispielweise die optischen Eigenschaften oder die Barriereeigenschaften der Kunststofffolie gegenüber Wasserdampf und/oder Sauerstoff zu verändern (US 2012/052244 A1).

Für das Auftragen derartiger Schichten auf die Oberfläche großflächiger Kunststofffolien haben sich insbesondere Verfahren der Chemischen Gasphasenabscheidung (auch Chemical Vapor Deposition oder kurz CVD genannt) bewährt, weil mit diesen Verfahren hohe Abscheideraten erzielt und eine große Vielfalt von Schichtmaterialien abgeschieden werden können. Dabei hat es sich als vorteilhaft erwiesen, Verfahren der Chemischen Gasphasenabscheidung unter Einwirkung eines Plasmas durchzuführen, um Ausgangsstoffe für eine chemische Reaktion aufzuspalten und anzuregen. Derartige Verfahren werden auch als Plasma Enhanced Chemical Vapor Deposition oder kurz PECVD genannt.

JP 2014 133349 A beschreibt Verfahren zum Herstellen eines Barriereschichtsystems gegenüber Wasserdampf und Sauerstoff, wobei das Barriereschichtsystem aus einem flexiblen Kunststoffsubstrat und einer darauf mittels PECVD abgeschiedenen Barriereschicht besteht. Um das Haften der Barriereschicht auf dem Kunststoffsubstrat zu verbessern wird vorgeschlagen, entweder ein Kunststoffsubstrat mit einem Harzanteil zu verwenden oder zunächst eine organische Schicht (beispielsweise aus einem aushärtbaren Kunstharz) auf dem Substrat abzuscheiden, bevor die Barriereschicht mittels PECVD abgeschieden wird. Zum Aushärten der Kunstharzschicht kann UV-Strahlung oder ein Elektronenstrahl verwendet werden.

DE 10 2008 028 542 A1 offenbart PECVD-Verfahren, bei denen ein Magnetron zum Erzeugen eines Plasmas verwendet wird. Ein dabei verwendetes Magnetron wird vorrangig zum Erzeugen des Plasmas genutzt. Ein Abtragen von Partikeln vom Magnetrontarget und ein Eintrag dieser Partikel in eine auf einem Substrat abgeschiedene Schicht sind hingegen nicht erwünscht.

Weitere PECVD-Verfahren sind aus DE 10 2008 050 196 A1 bekannt. Beim dynamischen Beschichten einer Kunststofffolie wird auch hier ein Magnetron zum Erzeugen eines Plasmas verwendet, wobei in Bewegungsrichtung der Kunststofffolie ein Monomereinlass entweder vor oder nach dem Magnetron angeordnet wird, um eine auf der Kunststofffolie abgeschiedene Schicht mit einem Gradienten auszubilden. Dabei kann optional, mit vom Magnetrontarget abgestäubten Partikeln, ein Beitrag zur Schichtabscheidung geleistet werden.

Auch in DE 10 2010 055 659 A1 werden Magnetron-PECVD-Verfahren beschrieben, die beim Abscheiden dielektrischer Schichten auf Kunststoffsubstraten zum Einsatz gelangen. Dabei werden während des Magnetronzerstäubens ein siliziumhaltiger Precursor und ein Reaktivgas in die Vakuumkammer eingelassen. Am Schichtaufbau sind sowohl Reaktionsprodukte abgestäubter Magnetrontargetteilchen mit dem Reaktivgas als auch Reaktionsprodukte des Precursors mit dem Reaktivgas beteiligt.

Allen bekannten Verfahren ist gemein, dass die auf diese Weise realisierten Schichtverbünde, bestehend aus Kunststoffsubstrat und darauf abgeschiedener Schicht bzw. darauf abgeschiedener Schichten, nur eine begrenzte mechanische Stabilität insbesondere hinsichtlich Biegeverhalten oder Dehnbarkeit aufweisen, die einer erforderlichen Beanspruchung oftmals nicht standhält. Eine funktionsgemäße Handhabung derartiger Produkte kann somit zur Rissbildung im Schichtsystem und folglich zum Einschränken der Funktionstüchtigkeit führen. Es ist bekannt, die Flexibilität derartiger Schichtverbünde zu erhöhen, indem organische Komponenten bei der Schichtabscheidung beteiligt werden, welche zu einer organischen Vernetzung bzw. organischen Teilvernetzung der abgeschiedenen Schicht führen. Dennoch ist die damit erzielbare Flexibilität und Dehnbarkeit der Schichtverbünde oftmals nicht hinreichend bzw. nicht langzeitstabil.

Der Erfindung liegt daher das technische Problem zugrunde, ein Verfahren zum Herstellen eines Schichtverbundes zu schaffen, mittels dem die Nachteile aus dem Stand der Technik überwunden werden. Insbesondere soll mit der Erfindung ein Verfahren zum Herstellen eines Schichtverbundes, bestehend aus Kunststofffolie und mindestens einer darauf abgeschiedener Schicht geschaffen werden, wobei der Schichtverbund eine höhere Dehnbarkeit bei Zug- und/oder Biegebelastung gegenüber dem Stand der Technik aufweist.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren zum Herstellen eines Schichtverbundes wird mindestens eine Schicht unmittelbar auf der Kunststofffolie mittels chemischer Gasphasenabscheidung innerhalb einer Vakuumkammer abgeschiedenen. Zwischen der Kunststofffolie und der abgeschiedenen Schicht befindet sich demzufolge keine weitere Schicht. Dabei weist die abgeschiedene Schicht einen mindestens 20-prozentigen Masseanteil eines metallenen Elements oder eines Halbleiterelements auf. Als metallenes Element sind besonders Titan sowie Aluminium und als Halbleiterelement Silizium geeignet. Während der Schichtabscheidung wird zumindest ein Monomer in die Vakuumkammer eingelassen und ein Plasma innerhalb der Vakuumkammer ausgebildet. Das Plasma kann beispielsweise mittels eines Sputter-Magnetrons oder mittels einer Hohlkathoden-Bogenentladung erzeugt werden. Optional kann während der Schichtabscheidung auch noch mindestens ein Reaktivgas, wie beispielsweise Stickstoff oder Sauerstoff, in die Vakuumkammer eingelassen werden.

Als ein wesentliches Merkmal der Erfindung wird die Schicht nach erfolgter Schichtabscheidung zumindest in einem Oberflächenbereich mit beschleunigten Elektronen beaufschlagt. Überraschend hat sich gezeigt, dass ein Schichtverbund aus einer Kunststofffolie und einer darauf abgeschiedenen Schicht, welche einen nicht vernachlässigbaren Anteil eines metallenen Elements oder eines Halbleiterelements von mindestens 20 Prozent Masseanteil aufweist, durch das Beaufschlagen mit beschleunigten Elektronen eine Verbesserung hinsichtlich Dehnbarkeit und Elastizität erfährt.

Bei einer Ausführungsform der Erfindung wird der Schichtverbund aus Kunststofffolie und abgeschiedener Schicht während des Beaufschlagens mit beschleunigten Elektronen über ein Kühlelement, wie beispielsweise eine Kühlwalze, geführt. Dies hat den Vorteil, dass hierbei (gegenüber einer Anordnung ohne Kühlelement) eine höhere Energiedosis bei gleicher Einwirkzeit in den Schichtverbund eingetragen werden kann, ohne den Schichtverbund dadurch zu schädigen. Alternativ kann das Beaufschlagen der abgeschiedenen Schicht mit beschleunigten Elektronen jedoch auch in einem Bereich erfolgen, in welchem die Kunststofffolie kein Kühlelement berührt.

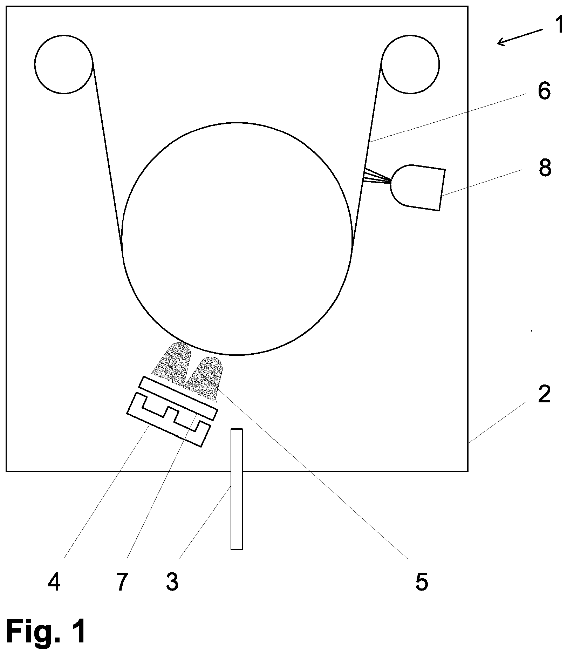

Die vorliegende Erfindung wird nachfolgend anhand eines Ausführungsbeispiels näher erläutert. In Fig. 1 ist eine Vorrichtung 1 schematisch dargestellt, mit welcher das erfindungsgemäße Verfahren durchführbar ist. In eine Vakuumkammer 2 werden durch einen Einlass 3 das Monomer HMDSO, das Reaktivgas Sauerstoff und das Arbeitsgas Argon eingelassen. Mittels eines Sputter-Magnetrons 4 wird innerhalb der Vakuumkammer 2 ein Magnetronplasma 5 erzeugt, welches das Monomer HMDSO aufspaltet sowie die aufgespaltenen Monomerbestandteile aktiviert und zur chemischen Schichtabscheidung anregt. Dabei reagieren die aufgespaltenen Monomerbestandteile mit dem Reaktivgas derart, dass auf einer durch die Vakuumkammer 2 geführten Kunststofffolie 6 eine organisch modifizierte Siliziumoxidschicht mit einer Schichtdicke von 200 nm abgeschieden wird. Die organisch modifizierte Siliziumoxidschicht weist somit neben den Elementen Silizium und Sauerstoff auch noch die Elemente Kohlenstoff und Wasserstoff auf.

Das Sputter-Magnetron, welches mit einem Titantarget bestückt ist, wird derart betrieben, dass möglichst kein Sputterabtrag am Target 7 erfolgt. Das Magnetron wird demzufolge nur zum Erzeugen des Plasmas verwendet. Alternativ kann ein Magnetron aber auch derart betrieben werden, dass ein Sputterabtrag am Magnetron erfolgt und die Sputterpartikel am Schichtaufbau beteiligt sind.

Ein Teil des auf diese Weise hergestellten Schichtverbundes aus Kunststofffolie 6 und abgeschiedener organisch modifizierter Siliziumoxidschicht wurde von der Folienrolle abgetrennt und einem Dehnungstest unterzogen. Unter einem Lichtmikroskop konnten bei einer Dehnung des Schichtverbundes von 1,7 % erste Risse in der abgeschiedenen Schicht festgestellt werden.

Der nicht dem Dehnungstest unterzogene Anteil der Schichtverbund-Folienrolle wurde anschließend abermals durch eine Vakuumkammer geführt, in welcher die abgeschiedene Schicht mit beschleunigten Elektronen beaufschlagt wurde. Hierfür wurde ein aus dem Stand der Technik bekannter Elektronengenerator 8 verwendet, der einen Flächenstrahl erzeugt. Hierfür können beispielsweise sogenannte Bandstrahler eingesetzt werden. Alternativ können aber auch andere Elektronengeneratoren verwendet werden, wie beispielsweise ein Axialstrahler, dessen fokussierter Elektronenstrahl nach einem vorgegebenen Muster, wie beispielsweise zeilenförmig über die Fläche der abgeschiedenen Schicht geführt wird, so dass die Fläche der abgeschiedenen Schicht mit dem Elektronenstrahl abgerastert wird. Bekanntlich ist die Eindringtiefe eines Elektronenstrahls in einen Gegenstand einstellbar. Beim erfindungsgemäßen Verfahren ist die Eindringtiefe eines verwendeten Elektronenstrahls vorzugsweise derart einzustellen, dass das Maximum des Energieeintrages des Elektronenstrahls innerhalb der abgeschiedenen Schicht ausgebildet wird.

Versuche mit verschiedenen Kunststofffolien und darauf abgeschiedener Schichtmaterialien unterschiedlichster Zusammensetzung haben gezeigt, dass das Beaufschlagen der abgeschiedenen Schicht mit beschleunigten Elektronen mit einer Mindestenergiedosis von 100 kJ/m² durchzuführen ist, um einen Vorteil hinsichtlich verbesserter Elastizitätseigenschaften des Schichtverbundes aus Kunststofffolie und darauf abgeschiedener Schicht zu erzielen. Der maximale Energieeintrag beschleunigter Elektronen in den Schichtverbund, ohne dabei eine Beschädigung des Schichtverbundes zu erzielen, ist abhängig von der jeweils verwendeten Kunststofffolie, der Materialzusammensetzung der abgeschiedenen Schicht und deren Schichtdicke, lässt sich aber in Laborversuchen einfach ermitteln.

Nach dem Beaufschlagen der abgeschiedenen Schicht mit beschleunigten Elektronen wurde ein Teil des auf diese Weise behandelten Schichtverbundes einem Dehnungstest unterzogen. Unter dem Lichtmikroskop konnten hierbei erst bei einer Dehnung von über vier Prozent erste Risse in der abgeschiedenen Schicht festgestellt werden. Das erfindungsgemäße Verfahren ist somit geeignet, einen Schichtverbund bestehend aus einer Kunststofffolie und einer darauf abgeschiedenen Schicht herzustellen, welcher eine gegenüber dem Stand der Technik verbesserte Dehnbarkeit bis zum Einsetzen einer Rissbildung aufweist.

Besonders geeignet ist das erfindungsgemäße Verfahren zum Herstellen eines Schichtverbundes, bei welchem Silizium als Halbleiterelement innerhalb der auf einer Kunststofffolie abgeschiedenen Schicht verwendet wird. Die abgeschiedene Schicht kann dabei auch zusätzlich noch mindestens eines der Elemente aus der Gruppe Kohlenstoff, Sauerstoff und Wasserstoff aufweisen. Derartige Schichten werden beispielsweise als Schichten mit einer Barrierewirkung gegenüber Wasserdampf und/oder Sauerstoff, als Kratzschutzschichten und als optische Schichten mit einem niedrigen Brechungsindex verwendet. Wird in der zuvor aufgelisteten Schichtzusammensetzung der Sauerstoff durch das Element Stickstoff ersetzt, kann die auf der Kunststofffolie abgeschiedene Schicht auch die Funktion einer optisch wirksamen Schicht mit einem hohen Brechungsindex ausüben. Alternativ kann eine optisch wirksame Schicht mit einem hohen Brechungsindex mit dem erfindungsgemäßen Verfahren auch hergestellt werden, wenn Titan als metallenes Element innerhalb der Schicht auf einer Kunststofffolie abgeschieden wird.

Für das Abscheiden einer Schicht mit den zuvor genannten Schichtzusammensetzungen mittels chemischer Gasphasenabscheidung kann beispielsweise mindestens eine der Komponenten HMDSO, HMDSN, TMS, TEOS, TEMAT, TDMAT, TMA, Titanpropoxid, Titaniso-propoxid in die Vakuumkammer eingelassen werden.

## Patentansprüche

1. Verfahren zum Herstellen eines Schichtverbundes aus einer Kunststofffolie (6) und mindestens einer unmittelbar auf der Kunststofffolie (6) mittels chemischer Gasphasenabscheidung innerhalb einer Vakuumkammer (2) abgeschiedenen Schicht, welche einen mindestens 20-prozentigen Masseanteil eines metallenen Elements oder eines Halbleiterelements aufweist, wobei während der Schichtabscheidung zumindest ein Monomer in die Vakuumkammer (2) eingelassen und ein Plasma (5) innerhalb der Vakuumkammer (2) ausgebildet wird, **dadurch gekennzeichnet, dass** die Schicht nach erfolgter Schichtabscheidung zumindest in einem Oberflächenbereich mit beschleunigten Elektronen, mit einer Energiedosis von mindestens 100 kJ/m² beaufschlagt wird.

2. Verfahren nach Anspruch 1, **dadurch gekennzeichnet, dass** ein Magnetron-Plasma (5) in der Vakuumkammer (2) ausgebildet wird.

3. Verfahren nach Anspruch 1, **dadurch gekennzeichnet, dass** ein Hohlkathoden-Plasma in der Vakuumkammer ausgebildet wird.

4. Verfahren nach Anspruch 1, **dadurch gekennzeichnet, dass** zusätzlich noch ein sauerstoffhaltiges und/oder stickstoffhaltiges Reaktivgas in die Vakuumkammer (2) eingelassen wird.

5. Verfahren nach Anspruch 1, **dadurch gekennzeichnet, dass** die abgeschiedene Schicht mit beschleunigten Elektronen beaufschlagt wird, während der Schichtverbund über eine Kühlwalze geführt wird.

6. Verfahren nach Anspruch 1, **dadurch gekennzeichnet, dass** Titan und/oder Aluminium als metallenes Element auf der Kunststofffolie abgeschieden wird.

7. Verfahren nach Anspruch 1, **dadurch gekennzeichnet, dass** Silizium als Halbleiterelement auf der Kunststofffolie (6) abgeschieden wird.

8. Verfahren nach Anspruch 7, **dadurch gekennzeichnet, dass** neben Silizium mindestens eines der Elemente aus der Gruppe Kohlenstoff, Wasserstoff, Sauerstoff, Stickstoff auf der Kunststofffolie (6) abgeschieden wird.

9. Verfahren nach Anspruch 1, **dadurch gekennzeichnet, dass** für das Abscheiden der Schicht mittels chemischer Gasphasenabscheidung mindestens eine der Komponenten HMDSO, HMDSN, TMS, TEOS, TEMAT, TDMAT, TMA, Titanpropoxid, Titan-isopropoxid in die Vakuumkammer (2) eingelassen wird.

## Claims

1. Method for producing a layer composite comprising a plastic film (6) and at least one layer which is deposited directly on the plastic film (6) by means of chemical vapour deposition within a vacuum chamber (2) and which has a proportion of at least 20 percent by mass of a metallic element or a semiconductor element, wherein, during the layer deposition, at least one monomer is admitted into the vacuum chamber (2) and a plasma (5) is formed within the vacuum chamber (2), **characterized in that**, after layer deposition has been effected, the layer, at least in a surface region, is exposed to accelerated electrons, with an energy dose of at least 100 kJ/m².

2. Method according to Claim 1, **characterized in that** a magnetron plasma (5) is formed in the vacuum chamber (2).

3. Method according to Claim 1, **characterized in that** a hollow cathode plasma is formed in the vacuum chamber.

4. Method according to Claim 1, **characterized in that** an oxygen-containing and/or nitrogen-containing reactive gas is additionally admitted into the vacuum chamber (2).

5. Method according to Claim 1, **characterized in that** the deposited layer is exposed to accelerated electrons while the layer composite is guided over a cooling roller.

6. Method according to Claim 1, **characterized in that** titanium and/or aluminium are/is deposited as metallic element on the plastic film.

7. Method according to Claim 1, **characterized in that** silicon is deposited as semiconductor element on the plastic film (6).

8. Method according to Claim 7, **characterized in that**, besides silicon, at least one of the elements from the group of carbon, hydrogen, oxygen, nitrogen is deposited on the plastic film (6) .

9. Method according to Claim 1, **characterized in that**, for depositing the layer by means of chemical vapour deposition, at least one of the components HMDSO, HMDSN, TMS, TEOS, TEMAT, TDMAT, TMA, titanium propoxide, titanium isopropoxide is admitted into the vacuum chamber (2).

## Revendications

1. Procédé pour la préparation d'un composite stratifié à partir d'une feuille de plastique (6) et d'au moins une couche déposée au moyen d'un dépôt chimique en phase gazeuse à l'intérieur d'une chambre à vide (2) directement sur la feuille de plastique (6), qui présente une proportion en masse d'au moins 20 pour cent d'un élément métallique ou d'un élément semi-conducteur, dans lequel pendant le dépôt de la couche au moins un monomère est introduit dans la chambre à vide (2) et un plasma (5) est formé à l'intérieur de la chambre à vide (2), **caractérisé en ce que** la couche, après le dépôt de couche réalisé, est soumise, au moins dans une zone superficielle, à des électrons accélérés dotés d'une dose d'énergie d'au moins 100 kJ/m².

2. Procédé selon la revendication 1, **caractérisé en ce qu'**un plasma magnétron (5) est formé dans la chambre à vide (2).

3. Procédé selon la revendication 1, **caractérisé en ce qu'**un plasma à cathode creuse est formé dans la chambre à vide.

4. Procédé selon la revendication 1, **caractérisé en ce qu'**en plus, un gaz réactif contenant de l'oxygène et/ou contenant de l'azote est introduit dans la chambre à vide (2).

5. Procédé selon la revendication 1, **caractérisé en ce que** la couche déposée est soumise à des électrons accélérés, pendant que le composite stratifié est conduit sur un cylindre de refroidissement.

6. Procédé selon la revendication 1, **caractérisé en ce que** du titane et/ou de l'aluminium sont déposés en tant qu'élément métallique sur la feuille de plastique.

7. Procédé selon la revendication 1, **caractérisé en ce que** du silicium est déposé en tant qu'élément semi-conducteur sur la feuille de plastique (6).

8. Procédé selon la revendication 7, **caractérisé en ce qu'**outre du silicium, au moins l'un des éléments du groupe du carbone, de l'hydrogène, de l'oxygène, de l'azote est déposé sur la feuille de plastique (6).

9. Procédé selon la revendication 1, **caractérisé en ce que** pour le dépôt de la couche au moyen d'un dépôt chimique en phase gazeuse, au moins un des composants HMDSO, HMDSN, TMS, TEOS, TEMAT, TDMAT, TMA, propoxyde de titane, isopropoxyde de titane est introduit dans la chambre à vide (2).
